# EUROPEAN PATENT APPLICATION

(11) **EP 1 662 578 A2**
(43) Date of publication of application: **31.05.2006**
(21) Application number: 05257206.2
(22) Date of filing: 23.11.2005
(51) Int. Cl.: H01L 31/0224, H01L 51/42

(54) **Electrode for photovoltaic cells and method of manufacture thereof**

(30) Priority: 24.11.2004 US 998071
(71) Applicant: GENERAL ELECTRIC COMPANY, Schenectady, NY 12345 (US)
(72) Inventor: Manivannan, Venkatesan, Rexford, New York 12148 (US); Gui, John Yupeng, Niskayuna, New York 12309 (US); Iacovangelo, Charles Dominic, Clifton Park, New York 12065 (US); Morrison, William Arthur, Albany, New York 12205 (US)
(74) Representative: Goode, Ian Roy

(57) **Abstract**

Disclosed herein is an article comprising a substrate (12); and a columnar structure, wherein the columnar structure comprises a semi-conductor and is disposed upon the substrate (12) in a manner wherein the longitudinal axis of the columnar structures is substantially perpendicular to the substrate (12). Disclosed herein is an electrode (10) that comprises a substrate (12) upon which is disposed an electron transport coating (14), wherein the electron transport coating (14) comprises a columnar structure.

## Description

This invention relates to electrodes for photovoltaic cells and methods for manufacture thereof. In particular this disclosure relates to electrodes having a columnar structure that can be used in a photovoltaic cell.

Photovoltaic systems convert light into electricity for a variety of applications. Photovoltaic systems are commonly known as "solar cells", so named for their ability to produce electricity from sunlight. Power production by photovoltaic systems may offer a number of advantages over other systems of generating electricity. These advantages are low operating costs, high reliability, modularity, low construction costs, as well as environmental benefits.

Solar cells convert light into electricity by exploiting the photovoltaic effect that exists at semiconductor junctions. Accordingly, solar cells generally comprise semiconductor layers to produce an electron current. The semiconductor layers absorb incoming light to produce excited electrons. In addition to the semiconductor layers, solar cells generally include a transparent cover or other encapsulant, an anti-reflective layer, a front contact substrate to allow the electrons to enter a circuit, and a back contact substrate to allow the electrons to complete the circuit when excited electrons are injected into the semiconductor layer due to light exposure.

In recent years progress has been made on the development of organic and inorganic-organic hybrid solar cells. These types of solar cells can be advantageously manufactured at a relatively low cost. One low cost solar cell is a dye-sensitized solar cell. A dye-sensitized solar cell generally uses an organic dye to absorb incoming light to produce excited electrons. The dye-sensitized solar cell generally includes two planar conducting substrates arranged in a sandwich configuration. A dye-coated semiconductor film separates the two substrates. The semiconductor film is porous and has a high surface area thereby allowing sufficient dye to be attached as a molecular monolayer on its surface to facilitate efficient light absorption. The remaining intervening space between the substrates and the pores in the semiconductor film (which acts as a sponge) is filled with an organic electrolyte solution containing an oxidation/reduction couple such as triiodide/iodide.

Dye-sensitized films, however, suffer from several technical drawbacks. One technical drawback is that a large transport distance results in substantial recombination or back reactions. Recombination occurs when an electron that has been ejected from a dye recombines with the oxidized absorber. Back reactions occur when a hole ejected into the hole transporter contacts an electron that has been ejected into the electron transporter without traveling through the external circuit.

Furthermore, oxidized dyes formed by the ejection of the electrons are generally reduced by a transfer of electrons from a reduced species in the photovoltaic cell. The reduced species are generally present in an electrolyte that in turn, becomes an oxidized species in the electrolyte (after giving up the electron). This oxidized species has to migrate toward the opposite substrate through the same long and torturous diffusion path. The oxidized species get reduced by receiving the electron from the substrate to complete the circuit.

During the random walk of the electron to the substrate, the electron may travel a significant distance, and the electron may be lost by combining with a component of the electrolyte solution. This is also known as "recombination." Under irradiation by sunlight, the density of electrons in the semiconductor may be very high such that such losses significantly reduce the maximum voltage and therefore the efficiency achievable by the solar cells. One technique for reducing the travel distance of the electron is to reduce the thickness of the semiconductor film and thus, the distance the electron has to travel to reach a substrate. Disadvantageously, reduction in the thickness of the semiconductor film may reduce the light absorption due to lower dye loading, thereby reducing the efficiency of the solar cell.

Another technical drawback of the current dye-sensitized solar cell is that the poor electron conduction of the TiO₂ film consisting of randomly interconnected nano-particles. TiO₂ films are generally used as electron transporters in solar cells. Further, in solar cells (photovoltaic cells) it is difficult to maximize the interfacial area of the TiO₂ electron transporter for optimal loading of the dye. Yet another drawback stems from the randomness of TiO₂ particles that form the film. This randomness or disorder creates a wide distribution in pore sizes. While extremely small pores prevent either dye molecules and/or the hole transporter molecules from entering into the pore, extremely large pores do not provide high surface/volume ratios. The inability of the dye molecules and/or the hole transporter molecules to enter into the pore results in increased recombination and/or back reactions. Similarly, the lack of a high surface to volume ratio promotes increased recombination and/or back reactions. This increased recombination and/or back reactions results in a loss of photon generated current.

It is therefore advantageous to minimize recombination and back-reactions by reducing the travel path of the electron and thereby reduce the length of time it takes for the electron to diffuse to the substrate while at the same time reducing the hole transport distance to another substrate. It is therefore desirable to develop solar cells or photovoltaic cells that have reduced charge transport distances and minimize or prevent recombinations and backreactions, and that can be easily mass-produced.

According to the present invention, there is provided an article comprising a substrate; and a columnar structure, wherein the columnar structure comprises a semi-conductor and is disposed upon the substrate in a manner wherein the longitudinal axis of the columnar structures is substantially perpendicular to the substrate.

Disclosed herein is an electrode that comprises a substrate upon which is disposed an electron transport coating, wherein the electron transport coating comprises a columnar structure.

Disclosed herein is a method comprising contacting a substrate with a plasma in an expanding thermal plasma generator, wherein the chamber pressure is about 30 millitorr to about 300 millitorr; and wherein the plasma comprises a reactive species and oxygen; and disposing a semiconducting coating up on the substrate, wherein the semiconducting coating comprises a columnar microstructure.

Embodiments of the invention will now be described, by way of example, with reference to the accompanying drawings, in which:
Figure 1 illustrates one exemplary embodiment of a cross-section of an electrode 10 incorporating an electron transport coating on a substrate 12;
Figure 2 is a scanning electron micrograph showing a titanium dioxide coating disposed upon a substrate 12;
Figure 3 is a schematic depiction a columnar structure disposed upon a substrate 12;
Figure 4 illustrates an example of a system 100 for forming the electron transport coating 14; and
Figure 5 illustrates one exemplary embodiment of a cross-section of a photovoltaic cell comprising an electrode 10 that comprises an electron transport coating disposed upon a substrate 12.

Disclosed herein is an article comprising a coating that has a columnar structure. The coating can advantageously be converted into an electron transport coating for use in a photovoltaic cell. The coating can also be used as an electrode in a photovoltaic cell. Such an electrode generally comprises a substrate upon which is disposed the electron transport coating having a columnar structure. The columnar structures are disposed upon the substrate with their longitudinal axis substantially perpendicular to the surface of the substrate. As will be detailed later, the longitudinal axis is parallel to the z-direction, which is perpendicular to the surface of the substrate. This configuration advantageously permits rapid electron transport thereby minimizing electron recombination within the photovoltaic cell. In one embodiment, the columnar structures are generated on the substrate by an expanded thermal plasma (ETP) process, which employs a pressure of about 30 to about 300 millitorr (mT).

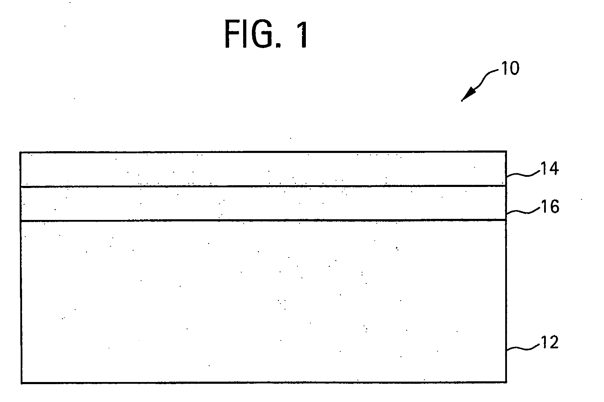

Figure 1 illustrates one exemplary embodiment of a cross-section of an electrode 10 incorporating an electron transport coating on a substrate 12. The electrode 10 may optionally include an interlayer 16 disposed between the substrate 12 and the electron transport coating 14 depending upon the application. The substrate 12 can be optionally pretreated to create an optional hydrophobic interlayer 16 on the surface. In one embodiment, the interlayer 16 can be an electrically conductive layer. Surface properties of the substrate 12 can be enhanced by use of adhesion promoters such as silicon or titanium alkoxides, which help to improve adhesion as well as cohesion between binding surfaces. The interlayer 16 may thus function as an adhesion layer between the substrate 12 and the electron transport coating 14 to promote adhesion between these layers, or may function to reduce stress between the substrate 12 and overlying layers, including the electron transport coating 14. The interlayer 16 may optionally comprise sublayers where one sublayer functions to reduce stress between the substrate 12 and the electron transport coating 14, and the other sublayer functions to promote adhesion between the substrate 12 and the electron transport coating 14. Alternatively, the interlayer 16 may provide both the functions of an adhesion layer and to reduce stress.

The electron transport coating can comprise a metal oxide, a semiconductor, carbon nanotubes, or the like. Exemplary electron transport coatings comprise semi-conductors. Suitable examples of semi-conductors are metal oxides. Examples of suitable metal oxides are silicon oxides (SiOₓ), silicon dioxides (SiO₂), titanium oxide (TiOₓ), titanium dioxide (TiO₂), zirconia (Zr₂O₃), alumina (Al₂O₃), hafnium oxide (HfO₂), or the like, or a combination comprising at least one of the foregoing metal oxides. As noted above, the metal oxide compositions can be stoichiometric. The metal oxide compositions can be non-stoichiometric as well. In another embodiment, some of the oxygen in the metal oxide can be replaced by another anion such as nitrogen. As a result, the columnar structures can also comprise oxynitrides. An example of an oxynitride is a metal oxynitride. Examples of oxynitrides are silicon oxynitride, titanium oxynitride, or the like, or a combination comprising at least one of the foregoing oxynitrides.

In one embodiment, when titanium oxide coatings are employed, a TiOₓ coating may comprise a stoichiometric TiO₂ coating, a non-stoichiometric TiOₓ coating where x is not equal to 2, or a combination thereof. In another embodiment, a suitable electron transport coating can comprise a combination of titanium dioxide and zirconia.

Examples of suitable n-type semiconductors that may be used to coat the substrate are doped silicon or germanium. Dopants for silicon are arsenic, phosphorus or antimony. Examples of carbon nanotubes are single wall carbon nanotubes, multiwall carbon nanotubes and vapor grown carbon fibers.

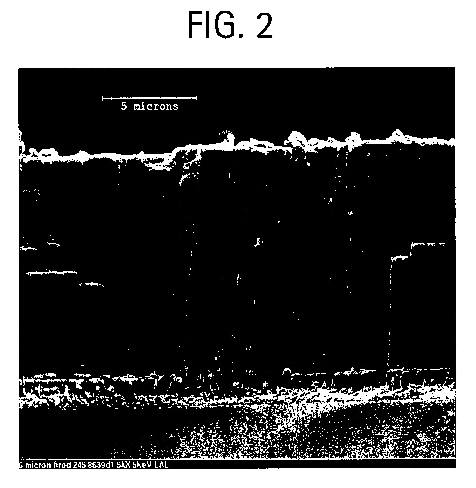

An exemplary electron transport coating that comprises columnar structures is one that comprises titanium dioxide (TiO₂). Figure 2 shows an electron micrograph of columnar structures of titanium dioxide as seen in a scanning electron microscope. As may be seen in the micrograph the titanium dioxide columnar structures are disposed substantially perpendicular to the surface of the substrate. The structures shown in the Figure 2 are ordered.

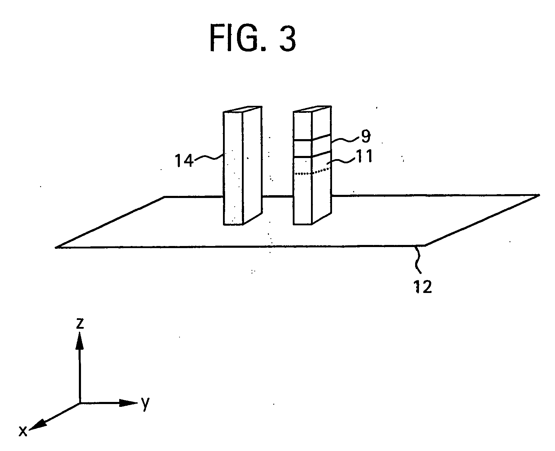

Figure 3 is a schematic showing the columnar structures disposed upon the substrate. The cross-sectional area of the column can have any geometry such as cylindrical, rectangular, square, or polygonal. In the Figure 3, the exemplary schematic has a rectangular cross-section.

In the Figure 3, the x and y axis lie parallel to the surface of the substrate that contacts the columnar structure. The columnar structure thus extends upwards from the surface of the substrate along the z axis. It is generally desirable for the smallest dimension in the x-y plane to be greater than or equal to about 5 nm. When the columnar structure is square or rectangular, it is generally desirable for the width of the columnar structure (as measured in the x-direction) to be greater than or equal to about 25 nm. In one embodiment, it is desirable for the width of the columnar structure to be greater than or equal to about 50 nm. It is generally desirable for the breadth of the columnar structure (as measured in the y-direction) to be greater than or equal to about 5 nm. In one embodiment, it is generally desirable for the breadth of the columnar structure to be greater than or equal to about 25 nm. In another embodiment, it is generally desirable for the breadth of the columnar structure to be greater than or equal to about 50 nm. It is generally desirable for the length of the columnar structure (as measured in the z-direction) to be greater than or equal to about 5 nanometers. In one embodiment, it is desirable for the length of the columnar structures to be greater than or equal to about 15 nanometers. In another embodiment, it is desirable for the length of the columnar structure to be greater than or equal to about 50 nanometers. In yet another embodiment, it is desirable for the length of the columnar structure to be greater than or equal to about 100 nanometers.

Individual columnar structures can contact each other at any point along their lengths or can be isolated from other columnar structures. In one embodiment, when the columnar structures are isolated, the space between two adjacent columnar structures is greater than or equal to about 5 nm. In another embodiment, the space between two adjacent columnar structures is greater than or equal to about 50 nm. In yet another embodiment, the space between two adjacent columnar structures is greater than or equal to about 100 nm. In yet another embodiment, the space between two adjacent columnar structures is greater than or equal to about 500 nm.

The columnar structures have an aspect ratio greater than or equal to about 2. The aspect ratio as defined herein is the ratio of the length of a columnar structure to the smallest surface dimension of the microstructure. In one embodiment, the columnar structures have an aspect ratio of greater than or equal to about 5. In another embodiment, the columnar structures have an aspect ratio of greater than or equal to about 10. In yet another embodiment, the columnar structures have an aspect ratio of greater than or equal to about 100.

It is desirable for the columnar structure to have a variety of porous structures. The columnar structure can have a nanoporous portion wherein the pores have a size of about 1 to about 10 nm. The pore size as referred to herein is the pore diameter. The columnar structure can also have porous portions that have pores larger than 10 nm. A given columnar structure can have alternating porous and nanoporous portions if desired. For example in the Figure 3, a first section 9 (measured along the z direction) of the columnar structure having a thickness of up to about 0.2 micrometer can be made nanoporous. A second section 11 disposed upon this first vertical section can have a porous structure (with pore sizes greater than 10 nm) for a thickness of up to about 0.2 micrometer. In this way, the entire length of the columnar structure can have alternating nanoporous and porous structures. In one embodiment (not shown), successive alternating columns can be made nanoporous or porous if desired. In another embodiment, several columns in a section of the substrate can be made nanoporous while several columns in an adjacent section of the substrate can be made porous with pore sizes greater than 10 nm if desired.

The titanium dioxide comprises a crystalline anatase phase, a brookite phase, a rutile phase, or a combination comprising at least one of the foregoing crystalline phases and has a high surface area of greater than or equal to about 5 square meters per gram (m²/gm). In one embodiment, the surface area of the columnar structure is greater than or equal to about 100 m²/gm. In another embodiment, the surface area of the columnar structure is greater than or equal to about 200 m²/gm. In yet another embodiment, the surface area of the columnar structure is greater than or equal to about 500 m²/gm. In yet another embodiment, the surface area of the columnar structure is greater than or equal to about 1,000 m²/gm.

It is desirable for the electron transport coating to have a thickness of about 5 nanometers to about 1 millimeter. In one embodiment, the electron transport coating has a thickness of about 100 nanometers to about 0.5 millimeter. An exemplary coating has a thickness of about 10 micrometers.

The substrate 12 can comprise any material that is flexible or rigid. An exemplary substrate 12 is a flexible substrate. A flexible substrate generally has a modulus of elasticity of less than or equal to about 10⁵ gigapascals (GPa) at room temperature. The substrate 12 can be optically transparent if desired. In one embodiment, the substrate can also be electrically conductive if desired. In another embodiment, the substrate can be electrically insulating but can be coated with an interlayer that is electrically conducting.

When the substrate is electrically conductive, it is desirable for the substrate to have a bulk volume resistivity of less than or equal to about 10¹² ohm-centimeter. In another embodiment, the substrate has a bulk volume resistivity of less than or equal to about 10⁸ ohm-centimeter. In yet another embodiment, the substrate has a bulk volume resistivity of less than or equal to about 10⁵ ohm-centimeter.

In one embodiment, the substrate can have a surface resistivity of less than or equal to about 1,000 ohm/square. In another embodiment, the substrate can have a surface resistivity of less than or equal to about 500 ohm/square. In yet another embodiment, the substrate can have a surface resistivity of less than or equal to about 100 ohm/square.

In another embodiment, the substrate can also be porous. The substrate can have a porosity of about 10 volume percent to about 90 volume percent. It is desirable for the substrate 12 and any interlayers disposed thereon to be capable of withstanding the temperatures involved in the process for depositing the electron transport coating. The substrate 12 can be formed by injection molding, extrusion, cold forming, vacuum forming, blow molding, compression molding, transfer molding, thermal forming, solvent casting, or the like.

Examples of suitable materials for substrates are glass, polymers, foils, or the like, or a combination comprising at least one of the foregoing materials. Examples of suitable glasses are silica, alumina, zirconia, titania, silicon oxynitride, titanium oxynitride, or the like. Examples of suitable polymers are thermoplastic polymers, thermosetting polymers, or a combination comprising at least one of the foregoing polymers. Examples of suitable thermoplastic polymers are polycarbonates, poly(meth)acrylates, polystyrenes, polyolefins, polyimides, polyetherimides, or the like, or a combination comprising at least one of the foregoing thermoplastic polymers. Examples of suitable thermosetting polymers are polyurethanes, polysiloxanes, epoxies, phenolics, or the like or a combination comprising at least one of the foregoing thermosetting polymers.

It is generally desirable to use metal foils as substrates. It is desirable for the foils to have a coefficient of thermal expansion that is favorable to the deposition of the metal oxide. Examples of suitable foils are those manufactured from aluminum, titanium, silver, platinum, zinc, molybdenum, tantalum, or the like, or a combination thereof. Examples of suitable alloys are steel, stainless steel, invar, or the like.

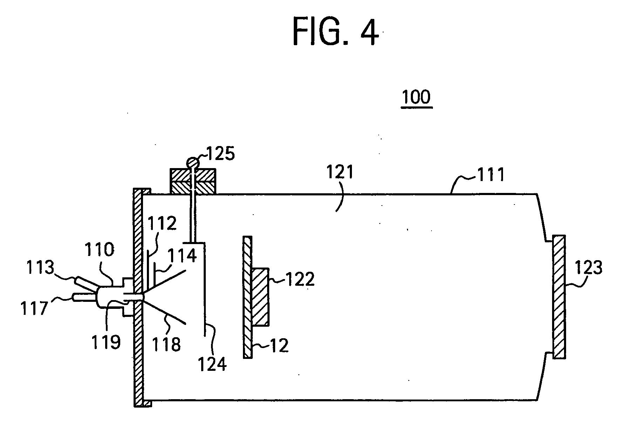

The electron transport coating 14 is advantageously formed by an expanding thermal plasma process (ETP), as discussed in more detail below. Figure 4 illustrates an example of a system 100 for forming the electron transport coating 14. The system 100 comprises a plasma generation chamber 110 and a deposition chamber 111. The deposition chamber 111 contains a substrate 12 mounted on a temperature controlled support 122. The substrate 12 may be a glass substrate, a polymeric substrate or a foil substrate, for example, coated with the optional interlayer 16, shown in the Figure 1. The deposition chamber 111 also contains a door (not shown) for loading and unloading the substrate 12 and an outlet 123 for connecting to a pump. The support 122 may be positioned at any position in volume 121 of deposition chamber 111. The substrate 12 may be positioned 10 to 50 cm, for example, and generally about 25.5 cm, from the anode 119 of the plasma generator.

The deposition chamber 111 also optionally comprises a retractable shutter 124. The shutter may be positioned, for example, by a handle 125 or by a computer controlled positioning mechanism. The shutter 124 may also contain a circular aperture to control the diameter of the plasma that emanates from the plasma generation chamber 110 towards the substrate 12. The deposition chamber 111 may also optionally comprise magnets or magnetic field generating coils (not shown) adjacent to chamber walls to direct the flow of the plasma.

The deposition chamber 111 may also contain an optional nozzle 118. The nozzle 118 provides improved control of the injection, ionization and reaction of the reactants to be deposited on the substrate 12. The nozzle 118 provides for the deposition of a material such as the electron transport coating on the substrate 12 and minimizes or even prevents formation of powdery reactant deposits on the substrate 12. Preferably, the nozzle 118, if employed, has a conical shape with a divergent angle of about 40 degrees and a length of about 10 to 80 cm, preferably about 16 cm. However, the nozzle 118 may alternatively have a variable cross section, such as such as conical-cylindrical-conical or conical-cylindrical. Furthermore, the nozzle 118 may have a divergent angle other than 40 degrees and a length other than 16 centimeter. The nozzle may also be omitted entirely. In the event that the nozzle is omitted, the feed tubes 112 and 114 feed into an injection ring.

The deposition chamber 111 also contains at least one reactant supply line. The number of reactant supply lines may be, for example, two or more. For example, the deposition chamber 111 may contain a first reactant supply line 112 and a second reactant supply line 114 to deposit the electron transport coating film on the substrate 12. The supply lines 112 and 114 preferably communicate with the nozzle 118 and supply reactants into the plasma flowing through the nozzle. The deposition chamber 111 also generally contains vacuum pumps (not shown) for evacuating the chamber 111.

The plasma generation chamber 110 contains at least one cathode 113, a plasma gas supply line 117 and an anode 119. The plasma generation chamber 110 generally comprises three cathodes 113 of which any one can be utilized. The cathodes 113 may comprise, for example, thorium or lanthanum doped tungsten tips. An exemplary tip is a lanthanum doped tungsten tip. The use of lanthanum allows the temperature of the tips to be maintained below the melting point of tungsten, thus avoiding contamination of the plasma with tungsten atoms and lessens changes in the geometry of the tip.

The plasma generation chamber 110 generally includes at least one plasma gas supply line 117. To form a plasma in the plasma generation chamber 110, a plasma gas is supplied through plasma gas supply line 117. The plasma gas may suitably comprise a noble gas, such as argon or helium, or a reactive gas, such as nitrogen, ammonia, carbon dioxide or hydrogen or any mixture thereof. If there is more than one plasma gas, then other gasses may be supplied through plural supply lines, if desired. Preferably, for the TiOₓ deposition, the plasma gas comprises argon. The plasma gas in plasma generation chamber 110 is maintained at a higher pressure than the pressure in the deposition chamber 111, which is continuously evacuated by a pump. An arc voltage is then applied between the cathode(s) 113 and the anode 119 to generate a plasma in the plasma generation chamber 110. The plasma then extends through the aperture of the anode 119 into the deposition chamber 111 due to the pressure difference between chambers 110 and 111. The reactants are supplied into the plasma through supply lines 112 and 114.

In one embodiment, in one method of manufacturing an electrode 10, a substrate 12 may comprise, for example, a low temperature substrate of polycarbonate with an optional interlayer formed on the polycarbonate. The substrate is provided in the deposition chamber 111 of the system 100 of Figure 4. A plasma is generated using a plasma gas supplied by plasma gas line 117. The plasma gas may be, for example, a noble gas. In one embodiment, the plasma gas is argon.

Suitable precursors for forming a TiOₓ film on the substrate are titanium tetrachloride (TiCl₄), titanium isopropoxide, titanium butoxide, titanium di-isopropoxide bis (2,4 pentanedionate), titanium (IV) ethoxide, titanium (IV) 2-ethylhexoxide, titanium (IV) isobutoxide, titanium (IV) methoxide, or the like, or a combination comprising at least one of the foregoing precursors. Suitable oxidants are oxygen, nitrous oxide, hydrogen peroxide, ozone, or water.

In one exemplary embodiment, in one method of manufacturing an electron transport coating comprising TiOₓ on a substrate, a first reactant comprising titanium is reacted with a second reactant comprises oxygen. The first reactant comprises titanium tetrachloride (TiCl₄) while the second reactant comprises oxygen. The first and second reactants react to form a TiOₓ film on the substrate. The flow rate for the TiCl₄ reactant is about 0.1 to about 1 standard liters per minute (slm) while the flow rate for the oxygen is about 0.4 to about 10 slm. An exemplary power for the deposition of the TiOₓ coating is about 20 to about 5000 watts DC power. An exemplary current is about 1 to about 100 amperes, while an exemplary voltage is about 20 to about 50 volts. High quality TiOₓ films can be deposited at a rate greater than or equal to about 1 micrometer per minute.

In one embodiment, during the expanded thermal plasma process, a chamber pressure of about 30 millitorr (mT) to about 300 mT can be used. In another embodiment, the chamber pressure during the process can be about 35 to about 200 mT. In yet another embodiment, the chamber pressure during the process can be about 45 to about 100 mT.

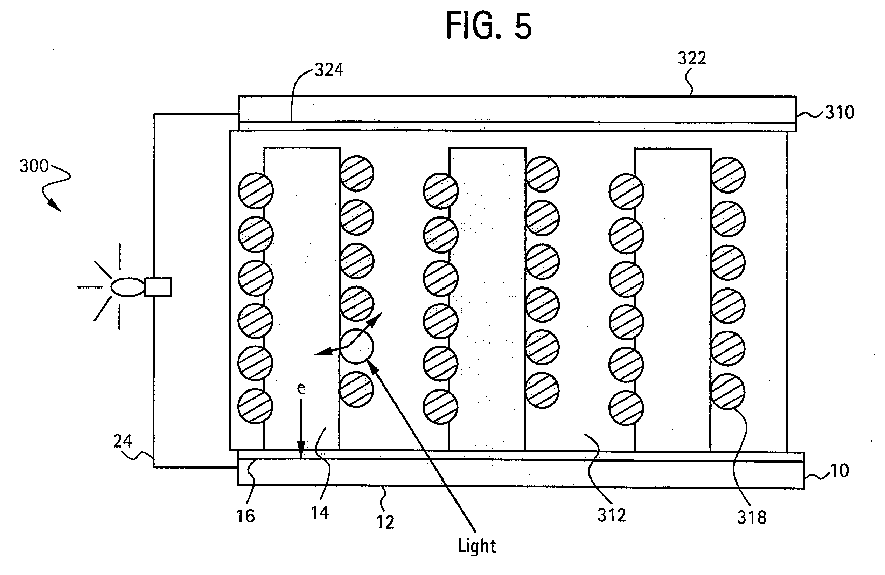

As noted above, the electrode can be advantageously used in a photovoltaic cell. In one exemplary embodiment, depicted in the schematic (not to scale) in Figure 5, a photovoltaic cell 300 comprises a first electrode 10 and a second electrode 310. The second electrode is termed the counter electrode and it may optionally be utilized in a photovoltaic cell application. Disposed between the opposing faces of the electrodes are an absorber 318, the electron transport coating 14 and a hole transporter 312. The absorber 318 is in electrical communication with the electron transport coating 14 and the hole transporter 312 respectively. The absorber is generally a dye that can absorb electromagnetic radiation and can eject an electron into the electron transport coating 14, while at the same time ejecting a hole into the hole transporter 312.

In one embodiment, the two electrodes have at least one electrically conductive surface or interlayer that is in electrical communication with either the electron transport coating 14 or the hole transporter 312. In one embodiment, the first electrode 10 comprises a first substrate 12 and a first conductive surface (also known as the interlayer) 16 that communicates electrically with the electron transport coating 14 while the second electrode 310 comprises a second substrate 322 and a second conductive surface (or interlayer) 324 that communicates with the hole transporter 312. The substrate 12 can advantageously serve as a mechanical support for the conductive surface 16.

With reference again to the photovoltaic cell 300 of Figure 5, when light impinges upon the absorber 318, it absorbs the incident radiation and ejects an electron. As shown in the Figure 5, the electron is ejected into the electron transport coating 14 and travels to the first electrode 10. A hole is simultaneously ejected into the hole transporter 312 and travels to the second electrode 310. The electron then travels through an external electrical circuit 24 and recombines with the hole to produce electricity. The external electrical circuit 24 as referenced herein pertains to elements that are in electrical communication with the electrodes and not in communication with the internal components of the photovoltaic cells such as the absorbing molecule, the electron and hole transporter, the insulating molecules, charge separators or ionic dopants.

In one embodiment, the photovoltaic cell 300 of Figure 5 can have the first electrode 10 comprising a transparent and/or flexible substrate 12 while the electron transport coating 14 comprises a columnar structure comprising titanium dioxide and the second electrode 310 comprising a flexible and/or transparent substrate 322 which may be the same or different from the substrate used in the first electrode. In one embodiment, the second electrode 310 comprises an electrically conductive surface 324. In another embodiment, the second electrode 310 comprises an electron transport coating that comprises columnar structures that are aligned perpendicular to the surface of the substrate of the second electrode. The columnar structures used in the second electrode 310 can comprise a metal oxide or conductive carbon nanotubes.

In another embodiment, the photovoltaic cell 300 of Figure 5 can have the first electrode 10 comprising a substrate 12. The substrate 12 has disposed upon its surface an electrically conducting interlayer 16. The electrically conducting interlayer 16 is disposed between the substrate 12 and the electron transport coating 14. The electrically conducting interlayer is therefore in contact with the columnar structure. The electrically conducting interlayer comprises indium tin oxide, F-doped transparent oxides, conductive polymers, metallic thin films, metal foils, or a combination comprising at least one of the foregoing electrically conductive coatings. The electrically conductive interlayer can optionally contact the external circuit 24. The substrate 12 can be transparent, and can be either flexible or rigid.

After the deposition of the columnar structure of Ti02 on the substrate 12 or the electrically conducting interlayer 16, it can be subjected to sintering. Sintering is conducted at a temperature of about 300 to about 500°C for a time period of 10 minutes to 1 hour. Sintering can be conducted in a vacuum or under a gaseous blanket. A suitable gaseous blanket is oxygen. The sintering facilitates the conversion of the columnar structure from an amorphous form to a crystalline form. Exemplary crystalline forms are anatase, rutile, brooklite, or a combination comprising at least one of the foregoing forms. After sintering the columnar structures can still comprises a minor amorphous phase.

In one embodiment, a photovoltaic cell comprising electrodes manufactured by the method disclosed herein can generate an electrical density of greater than or equal to about 5 milliamperes/cm². The surface area in square centimeters refers to the flat surface of the cell. In another embodiment, a photovoltaic cell comprising electrodes manufactured by the method disclosed herein can generate an electrical density of greater than or equal to about 10 milliamperes/cm². In yet another embodiment, a photovoltaic cell comprising electrodes manufactured by the method disclosed herein can generate an electrical density of greater than or equal to about 20 milliamperes/cm². The columnar structures can be tailored to produce current densities of greater than or equal to about 50 milliamperes/cm².

Photovoltaic cells comprising electrodes manufactured by the method disclosed herein can have an efficiency of greater than or equal to about 5%. In another embodiment, photovoltaic cells comprising electrodes manufactured by the method disclosed herein can have an efficiency of greater than or equal to about 10%. In yet another embodiment, photovoltaic cells comprising electrodes manufactured by the method disclosed herein can have an efficiency of greater than or equal to about 15%.

The following examples, which are meant to be exemplary, not limiting, illustrate compositions and methods of manufacturing of some of the various embodiments of the electrodes for photovoltaic cell described herein.

### EXAMPLE

Examples 1 - 3 below were undertaken to demonstrate the formation of columnar structures of titanium dioxide on a glass substrate when the pressure in the reaction chamber of an expanded thermal plasma is varied from about 45 to about 100 millitorr (mT). The titanium dioxide precursors that were used were titanium chloride or titanium isopropoxide. Argon was fed into an expanding thermal plasma generator. Oxygen along with the precursors were fed into the reaction chamber at about 3 centimeters from the anode. The temperature of the substrate during deposition can be varied from about 100 to about 150°C. In these examples, the substrate was maintained at a temperature of about 150°C. The pressure in the reaction chamber was maintained either at 45 mT or at 100 mT. The as-deposited materials were amorphous in nature and upon further sintering at a temperature of 450°C, they were converted into the desired materials with the required stoichiometry thereby forming crystalline columnar structures comprising anatase. The time for the sintering was 30 minutes. The columnar structures obtained upon such annealing are generally completely crystalline. In some instances, the columnar structures have a minor portion of an amorphous phase.

The substrates were subjected to varied reaction conditions to form the titanium dioxide layers, which are described in each of the examples below. The substrates together with the columnar structures were tested in photovoltaic cells and the efficiency was noted. The cell was manufactured as follows.

The glass substrates with the columnar structures disposed thereon were sintered. The glass plates were dyed with Ru dye (N3) at 40°C for 1 hour. The cell was constructed using a 40 micrometer PRIMACOR® gasket. Acetonitrile was used as electrolyte in the cell. Platinum coated glass was used as counter electrode and the cells were constructed by sandwiching the 2 plates under pressure. The pressure was 2.8 kg/cm² and the temperature was 90°C. The cells were tested in solar stimulator under standard testing conditions as specified by NREL certified Silicon standards.

### Example 1.

In this example, titanium dioxide columnar structures were deposited on a glass substrate. The conditions are shown in the Table 1 below. The sample was translating.

**Table 1**

| Power (kW) | Flow rate (Argon) (slm) | Flow rate (Oxygen) (slm) | Flow rate (TiCl₄) (slm) | Reaction Chamber Vacuum (millitorr) |
|---|---|---|---|---|
| 3 | 3 | 5 | 0.2 | 100 |

The as-deposited coating was amorphous in nature and upon further sintering at a temperature of 450°C for 30 minutes was converted into crystalline columnar structures comprising anatase. The coating thickness after sintering was about 8.1 to about 8.6 micrometers. The glass plate thus coated was utilized in a photovoltaic cell and the efficiency of the cell was determined to be 6%. The photovoltaic cell was manufactured as described above.

### Example 2

In this example, titanium dioxide was deposited on a glass substrate. The glass substrate was subjected to a stationary deposition for 4 minutes under the conditions shown in the Table 2.

**Table 2**

| Power (kW) | Flow rate (Argon) (slm) | Flow rate (Oxygen) (slm) | Flow rate (TiCl₄) (slm) | Reaction Chamber Vacuum (millitorr) |
|---|---|---|---|---|
| 3 | 3 | 5 | 0.2 | 45 |

As in example 1 above, the as-deposited coating was amorphous in nature and upon further sintering at a temperature of 450°C, was converted into crystalline columnar structures comprising anatase. The average coating thickness after sintering was 12.0 micrometers. The glass substrate thus coated was used in a photovoltaic cell. The photovoltaic cell was manufactured as described above. The efficiency of the cell was 7.2%.

### Example 3

In this example, titanium dioxide was deposited on a glass substrate. The glass substrate was first preheated by parking the substrate in front of the arc and then subjected to a stationary deposition for 4 minutes under the conditions shown in the Table 3.

**Table 3**

| Power (kW) | Flow rate (Argon) (slm) | Flow rate (Oxygen) (slm) | Flow rate (TiCl₄) (slm) | Reaction Chamber Vacuum (millitorr) |
|---|---|---|---|---|
| 3 | 3 | 5 | 0.2 | 45 mT |

As in example 1 and 2 above, the as-deposited materials was amorphous in nature and upon further sintering at a temperature of 450°C was converted into crystalline columnar structures comprising anatase TiO₂. The coating thickness after sintering was about 6.9 to about 7.2 micrometers. The glass substrate thus coated was used in a photovoltaic cell. The photovoltaic cell was manufactured as described above. The efficiency of the cell was less than 2%.

### Example 4

In this example, titanium dioxide was deposited on a glass substrate. This example was similar to Example 3, except that the glass substrate was not preheated. The glass plate was subjected to a stationary deposition for 4 minutes under the conditions shown in the Table 4.

**Table 4**

| | | | | |
|---|---|---|---|---|
| Power (kW) | Flow rate (Argon) (slm) | Flow rate (Oxygen) (slm) | Flow rate (TiCl₄) (slm) | Reaction Chamber Vacuum (millitorr) |
| 3 | 3 | 5 | 0.2 | 45 mT |

As in example 1 and 2 above, the as-deposited materials was amorphous in nature and upon further sintering at a temperature of 450°C was converted into crystalline columnar structures comprising anatase TiO₂. The coating thickness after sintering was about 6.15 to about 6.4 micrometers. The glass substrate thus coated was used in a photovoltaic cell. The photovoltaic cell was manufactured as described above. The efficiency of the cell was 4.7%.

### Example 5

This example demonstrates the formation of zinc oxide (ZnO) structures on a glass substrate. The reactive precursor was dimethyl zinc. The dimethyl zinc was introduced into the reaction chamber in a 1.0M solution in heptane. ZnO deposited for 10 minutes in reaction chamber. The reaction conditions are shown in the Table 5.

**Table 5**

| Power (kW) | Flow rate (Argon) (slm) | Flow rate (Oxygen) (slm) | Flow rate (DMZ) (slm) | Reaction Chamber Vacuum (millitorr) |
|---|---|---|---|---|
| 3 | 3 | 5 | 0.5 | 45 mT |

The average coating thickness was around 12.6 micrometers before sintering. This sample was sintered and a photovoltaic cell was constructed as detailed above. The measured efficiency of the photovoltaic was 0.3%.

### Example 6

This example demonstrates the deposition of a titanium dioxide coating on a titanium foil substrate. The titanium foil was subjected to 25 passes through the reaction chamber with a pause of about 1 minute between each pass. The speed of the titanium foil during each pass through the chamber was 2.5 centimeter per second. The reaction conditions are shown below in the Table 6.

**Table 6**

| Power (kW) | Flow rate (Argon) (slm) | Flow rate (Oxygen) (slm) | Flow rate (TiCl₄) (slm) | Reaction Chamber Vacuum (millitorr) |
|---|---|---|---|---|
| 3 | 3 | 5 | 0.2 | 45 mT |

The coating thickness was about 8 to about 10 micrometers after sintering.

### Example 7

This example demonstrates the difference in photovoltaic cell characteristics when sintered electrodes and non-sintered electrodes are used in photovoltaic cells. The sintered and non-sintered electrodes both contain an electron transport coating comprising titanium dioxide columnar structures. The titanium dioxide electron transport coating had an average thickness of about 10 micrometers after sintering. The substrate comprised glass.

Two photovoltaic cells, one having a sintered electron transport coating and one containing a coating that was not subjected to sintering were tested in a photovoltaic cell. The sintering was conducted at 450°C as described above and resulted in a conversion of amorphous titanium dioxide to crystalline (anatase) titanium dioxide. The deposition of the electron transport coating for the sintered cell has already been described in Example 2 above. The cells were manufactured as described above. The results for the cells are shown in the Table 7 below.

**Table 7**

| | Non-sintered Cell | Sintered Cell |
|---|---|---|
| Efficiency (%) | 0.4 | 7.2 |
| Voc (Open Circuit Voltage) | 0.6 | 0.543 |
| Current Density (mA/cm²) | 0.97 | 21 |
| Fill Factor* | 0.68 | 0.63 |

| | | |
|---|---|---|
| Fill Factor = Max output power/(Short Circuit Current x Open circuit voltage) | | |

From the Table 7, it may be seen that the sintered cell, which has the crystalline electron transport coating has a much higher efficiency of 7.2% than the non sintered cell, which has an efficiency of only 0.4%. It can also be observed that the current density is 21 milliamperes per square centimeter (mA/cm²) for the sintered cell.

From the above examples, it can be seen that the expanding thermal plasma process can be advantageously used to produce electrodes have columnar structures that facilitate increased efficiencies in photovoltaic cells. The columnar structures upon crystallization reduce electron recombination in a photovoltaic cell. The electron transport coatings can also be advantageously deposited at low temperatures.

For completeness, various aspects of the invention are set out in the following numbered clauses:
1. An article comprising:
   a substrate; and
   a columnar structure, wherein the columnar structure comprises a semi-conductor and is disposed upon the substrate in a manner wherein the longitudinal axis of the columnar structures is substantially perpendicular to the substrate.
2. The article of Clause 1, wherein the substrate is optically transparent, porous and/or electrically conductive.
3. The article of Clause 1, wherein the substrate is optically transparent, non-porous and/or electrically conductive.
4. The article of Clause 1, wherein the substrate has a modulus of elasticity of less than or equal to about 10⁵ GPa at room temperature.
5. The article of Clause 1, wherein the substrate comprises glass, polymers, metal foils or a combination thereof.
6. The article of Clause 1, wherein the substrate comprises silica, alumina, zirconia, titania, a thermoplastic polymer, a thermosetting polymer, or a combination thereof.
7. The article of Clause 1, wherein the semi-conductor is a metal oxide, and wherein the metal oxide is non-stoichiometric or stoichiometric.
8. The article of Clause 1, wherein the semi-conductor is titanium oxide, and wherein the titanium oxide is non-stoichiometric or stoichiometric.
9. The article of Clause 8, wherein the titanium dioxide has a crystalline structure.
10. The article of Clause 1, wherein the columnar structure has an aspect ratio of greater than or equal to about 5.
11. The article of Clause 1, wherein the columnar structure is disposed on the substrate in the form of a coating.
12. The article of Clause 11, wherein the coating has a thickness of about 5 nanometers to about 1 millimeter.
13. The article of Clause 11, wherein the coating has a surface area of greater than or equal to about 5 square meters per gram.
14. The article of Clause 1, wherein the columnar structure has a cross-sectional area that is circular, rectangular, square or polygonal.
15. The article of Clause 1, wherein the columnar structure comprises a metal oxynitride.
16. The article of Clause 1, wherein the columnar structure has a minimum size of 5 nanometers when measured in a plane parallel to the surface of the substrate.
17. The article of Clause 1, wherein the columnar structure has a length of greater than or equal to about 5 nanometers when measured in a plane perpendicular to the surface of the substrate.
18. The article of Clause 1, wherein any two adjacent columnar structures are separated from each other by about 5 to about 500 nanometers.
19. The article of Clause 1, wherein the columnar structure comprises alternating sections that are nanoporous and porous, and wherein the nanoporous sections have pores of about 1 to about 10 nanometers in diameter, and wherein the porous sections have pores greater than 10 nanometers in diameter.
20. The article of Clause 19, wherein the nanoporous section has a thickness of less than or equal to about 0.2 micrometer, while the porous section has a thickness of less than or equal to about 0.2 micrometer, and wherein the thickness is measured in a direction perpendicular to the surface of the substrate.
21. The article of Clause 1, wherein a columnar structure that is nanoporous is located next to a columnar structure that is porous.
22. The article of Clause 1, wherein the columnar structure is formed in an expanding thermal plasma.
23. The article of Clause 1, wherein the columnar structure comprises a rutile crystalline phase, an anatase crystalline phase, a brooklite phase or a combination comprising at least one of the foregoing crystalline phases.
24. The article of Clause 1, wherein the columnar structure comprises an amorphous phase.
25. The article of Clause 1, wherein the article is used in a photovoltaic cell.
26. An electrode comprising:
   an electrically conductive substrate upon which is disposed an electron transport coating, wherein the electron transport coating comprises a columnar structure.
27. The electrode of Clause 26, wherein the columnar structure has a cross-sectional area that is circular, rectangular, square or polygonal.
28. The electrode of Clause 26, wherein the electron transport coating has a columnar structure that comprises a semi-conductor, a conductor, or a combination thereof.
29. The electrode of Clause 28, wherein the semiconductor comprises a metal oxide and wherein the conductor comprises carbon nanotubes.
30. The electrode of Clause 29, wherein the metal oxide is titanium oxide, and wherein the titanium oxide is non-stoichiometric or stoichiometric.
31. The electrode of Clause 30, wherein the titanium dioxide has a crystalline structure, and wherein the crystalline structure comprises a rutile phase, an anatase phase, a brooklite phase, or a combination comprising at least one of the foregoing crystalline phases.
32. The electrode of Clause 26, wherein the columnar structures have an aspect ratio of greater than or equal to about 2.
33. The electrode of Clause 26, wherein the columnar structure is disposed on the electrically conductive substrate such that the longitudinal axis of the columnar structure is substantially perpendicular to the electrically conductive substrate.
34. The electrode of Clause 26, wherein the coating has a thickness of about 5 nanometers to about 1 millimeter.
35. The electrode of Clause 26, wherein the columnar structures are formed in an expanding thermal plasma.
36. The electrode of Clause 26, wherein the electrically conductive substrate is optically transparent and/or porous.
37. The electrode of Clause 26, wherein the electrically conductive substrate has a modulus of elasticity of less than or equal to about 10⁵ GPa at room temperature.
38. The electrode of Clause 26, wherein the electrically conductive substrate comprises a supporting portion and an electrically conductive portion, wherein the electrically conductive portion is in contact with the columnar structure.
39. The electrode of Clause 38, wherein the electrically conductive portion is a coating that comprises indium tin oxide, F-doped transparent oxides, conductive polymers, metallic thin films, metal foils, or a combination comprising at least one of the foregoing.
40. The electrode of Clause 38, wherein the supporting portion comprises silica, alumina, zirconia, titania, a thermoplastic polymer, a thermosetting polymer, or a combination thereof.
41. The electrode of Clause 38, wherein the supporting portion comprises polycarbonates, poly(meth)acrylates, polystyrenes, polyolefins, polyimides, polyetherimides, polyurethanes, polysiloxanes, epoxies, phenolics, or a combination thereof.
42. The electrode of Clause 39, wherein the metal foil is aluminum, titanium, silver, platinum, zinc, molybdenum, tantalum, steel, invar, stainless steel, or a combination thereof.
43. The article of Clause 1, wherein the columnar structure has an aspect ratio of greater than or equal to about 5.
44. The electrode of Clause 26, wherein the columnar structure is disposed on the substrate in the form of a coating.
45. The electrode of Clause 44, wherein the coating has a thickness of about 5 nanometers to about 1 millimeter.
46. The electrode of Clause 44, wherein the coating has a surface area of greater than or equal to about 5 square meters per gram.
47. The electrode of Clause 26, wherein the columnar structure has a cross-sectional area that is circular, rectangular, square or polygonal.
48. The electrode of Clause 26, wherein the columnar structure comprises a metal oxynitride.
49. The electrode of Clause 26, wherein the columnar structure has a minimum size of 5 nanometers when measured in a plane parallel to the plane of the substrate.
50. The electrode of Clause 26, wherein the columnar structure has a length of greater than or equal to about 5 nanometers when measured in a plane perpendicular to the plane of the substrate.
51. The electrode of Clause 26, wherein any two adjacent columnar structures are separated from each other by about 5 to about 500 nanometers.
52. The electrode of Clause 26, wherein the columnar structure comprises alternating sections that are nanoporous and porous, and wherein the nanoporous sections have pores of about 1 to about 10 nanometers in diameter, and wherein the porous sections have pores greater than 10 nanometers in diameter.
53. The electrode of Clause 52, wherein the nanoporous section has a thickness of less than or equal to about 0.2 micrometer, while the porous section has a thickness of less than or equal to about 0.2 micrometer, and wherein the thickness is measured in a direction perpendicular to the substrate.
54. The electrode of Clause 26, wherein a columnar structure that is nanoporous is located next to a columnar structure that is porous.
55. The electrode of Clause 26, wherein the columnar structure is formed in an expanding thermal plasma.
56. The electrode of Clause 26, wherein the columnar structure comprises a rutile crystalline phase, an anatase crystalline phase, a brooklite phase or a combination comprising at least one of the foregoing crystalline phases.
57. The electrode of Clause 26, wherein the columnar structure comprises an amorphous phase.
58. A photovoltaic cell comprising the electrode of Clause 26.
59. A fuel cell comprising the electrode of Clause 26.
60. A method comprising:
   contacting a substrate with a plasma in an expanding thermal plasma generator, wherein the generator pressure is about 30 millitorr to about 300 millitorr; and wherein the plasma comprises a reactive species and oxygen; and
   disposing a semiconducting coating up on the substrate, wherein the semiconducting coating comprises a columnar microstructure.
61. The method of Clause 60, wherein the semi-conductor coating is formed at a rate of greater than or equal to about 1 micrometer/minute.
62. The method of Clause 60, wherein the reactant comprises titanium tetrachloride, titanium isopropoxide, titanium butoxide, titanium di-isopropoxide bis (2,4 pentanedionate), titanium (IV) ethoxide, titanium (IV) 2-ethylhexoate, titanium (IV) isobutoxide, titanium (IV) methoxide, or a combination comprising at least one of the foregoing precursors.
63. The method of Clause 60, wherein the plasma further comprises an oxidant, and wherein the oxidant is oxygen, nitrous oxide, hydrogen peroxide, ozone, or water.
64. The method of Clause 60, wherein the plasma comprises an argon plasma.
65. The method of Clause 60, wherein the columnar structure comprises titanium dioxide.
66. The method of Clause 60, further comprising sintering the substrate at a temperature of about 300 to about 500°C.

## Claims

1. An article comprising:
a substrate (12); and
a columnar structure, wherein the columnar structure comprises a semi-conductor and is disposed upon the substrate (12) in a manner wherein the longitudinal axis of the columnar structures is substantially perpendicular to the substrate (12).

2. The article of Claim 1, wherein the substrate (12) is optically transparent, porous and/or electrically conductive.

3. The article of Claim 1, wherein the substrate (12) is optically transparent, non-porous and/or electrically conductive.

4. An electrode (10) comprising:
an electrically conductive substrate (12) upon which is disposed an electron transport coating (14), wherein the electron transport coating comprises a columnar structure.

5. The electrode (10) of Claim 4, wherein the electron transport coating (14) has a columnar structure that comprises a semi-conductor, a conductor, or a combination thereof.

6. The electrode (10) of Claim 5, wherein the semiconductor comprises a metal oxide and wherein the conductor comprises carbon nanotubes.

7. The electrode (10) of Claim 4, wherein the columnar structures are formed in an expanding thermal plasma.

8. The electrode (10) of Claim 4, wherein the electrically conductive substrate (12) comprises a supporting portion and an electrically conductive portion, wherein the electrically conductive portion is in contact with the columnar structure.

9. The electrode (10) of Claim 4, wherein the electrically conductive portion is a coating that comprises indium tin oxide, F-doped transparent oxides, conductive polymers, metallic thin films, metal foils, or a combination comprising at least one of the foregoing.

10. A method comprising:
contacting a substrate (12) with a plasma in an expanding thermal plasma generator, wherein the generator pressure is about 30 millitorr to about 300 millitorr; and wherein the plasma comprises a reactive species and oxygen; and
disposing a semiconducting coating up on the substrate (12), wherein the semiconducting coating comprises a columnar microstructure.
